# EUROPEAN PATENT APPLICATION

(11) **EP 4 672 337 A2**
(43) Date of publication of application: **31.12.2025**
(21) Application number: 25184995.6
(22) Date of filing: 24.06.2025
(51) Int. Cl.: H01L 25/18, H01L 25/00, H01L 25/065, H01L 23/00, H10B 10/00, H10B 12/00, H10B 43/00

(54) **DEVICE, METHOD AND SYSTEM TO PROVIDE HETEROGENEOUS MEMORY CIRCUIT STACKING**

(30) Priority: 28.06.2024 US 202418759115
(71) Applicant: Intel Corporation, Santa Clara, CA 95054 (US)
(72) Inventor: SHARMA, Abhishek Anil, Portland, 97229 (US); SUTHRAM, Sagar, Portland, 97229 (US); GOMES, Wilfred, Portland, 97229 (US); GHANI, Tahir, Portland, 97229 (US); MURTHY, Anand, Portland, 97229 (US); RANADE, Pushkar, San Jose, 95134 (US)
(74) Representative: 2SPL Patentanwälte PartG mbB

(57) **Abstract**

Techniques and mechanisms for an integrated circuit (IC) die structure to comprise heterogeneous active layers which are variously stacked in respective face-to-back arrangements. In an embodiment, three active layers each correspond to a different respective transistor type, wherein two active layers comprise transistors of respective memory arrays, and a third active layer comprises transistors of circuitry which is coupled to access the memory arrays. In another embodiment, hybrid bond structures are disposed between two of the active layers.

## Description

### BACKGROUND

### 1. Technical Field

This disclosure generally relates to integrated circuitry and more particularly, but not exclusively, to a vertically stacked arrangement of memory arrays.

### 2. Background Art

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

In the manufacture of integrated circuit devices, multi-gate transistors, such as tri-gate transistors, have become more prevalent as device dimensions continue to scale down. In conventional processes, tri-gate transistors are generally fabricated on either bulk silicon substrates or silicon-on-insulator substrates. In some instances, bulk silicon substrates are preferred due to their lower cost and because they enable a less complicated tri-gate fabrication process. In another aspect, maintaining mobility improvement and short channel control as microelectronic device dimensions scale below the 10 nanometer (nm) node provides a challenge in device fabrication. Nanowires used to fabricate devices provide improved short channel control.

As successive generations of integrated circuit technologies continue to scale in size, speed, and power efficiency, there is expected to be an increasing premium placed on improvements to semiconductor structures and fabrication techniques.

### BRIEF DESCRIPTION OF THE DRAWINGS

The various embodiments of the present invention are illustrated by way of example, and not by way of limitation, in the figures of the accompanying drawings and in which:
FIG. 1 shows a perspective view diagram illustrating features of an integrated circuit device to access heterogeneous memory arrays which are vertically arranged over peripheral circuitry according to an embodiment.
FIG. 2 shows a flow diagram illustrating features of a method to fabricate an integrated circuit die structure comprising a vertical arrangement of heterogeneous memory arrays according to an embodiment.
FIG. 3 shows a cross-sectional side view diagram illustrating features of an integrated circuit system comprising memory arrays arranged over corresponding peripheral circuitry according to an embodiment.
FIG. 4 shows a cross-sectional side view diagram illustrating features of an integrated circuit system comprising a vertical arrangement of peripheral circuitry and heterogeneous memory arrays according to an embodiment.
FIGs. 5A, 5B show cross-sectional side view diagrams each illustrating a respective stage of processing to provide an integrated circuit device according to an embodiment.
FIGs. 6A through 6D show cross-sectional side view diagrams each illustrating a respective stage of processing to provide an integrated circuit device according to an embodiment.
FIG. 7 illustrates a diagram of an example data server machine employing an integrated circuit die comprising a stacked arrangement of active layers according to an embodiment.
FIG. 8 is a block diagram of an example computing device according to an embodiment.

### DETAILED DESCRIPTION

Embodiments discussed herein variously provide techniques and mechanisms for an integrated circuit (IC) die structure to comprise heterogeneous active layers which are stacked in various respective face-to-back arrangements. In an embodiment, some or all of the active layers each correspond to a different respective transistor type - e.g., wherein two such active layers comprise transistors of respective memory arrays, and a third such active layer comprises transistors of circuitry which is coupled to access the memory arrays.

The description herein includes numerous details to provide a more thorough explanation of the embodiments of the present disclosure. It will be apparent to one skilled in the art, however, that embodiments of the present disclosure may be practiced without these specific details. In other instances, well-known structures and devices are shown in block diagram form, rather than in detail, in order to avoid obscuring embodiments of the present disclosure.

Note that in the corresponding drawings of the embodiments, signals are represented with lines. Some lines may be thicker, to indicate a greater number of constituent signal paths, and/or have arrows at one or more ends, to indicate a direction of information flow. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

Throughout the specification, and in the claims, the term "connected" means a direct connection, such as electrical, mechanical, or magnetic connection between the things that are connected, without any intermediary devices. The term "coupled" means a direct or indirect connection, such as a direct electrical, mechanical, or magnetic connection between the things that are connected or an indirect connection, through one or more passive or active intermediary devices. The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

The term "scaling" generally refers to converting a design (schematic and layout) from one process technology to another process technology and subsequently being reduced in layout area. The term "scaling" generally also refers to downsizing layout and devices within the same technology node. The term "scaling" may also refer to adjusting (e.g., slowing down or speeding up - i.e. scaling down, or scaling up respectively) of a signal frequency relative to another parameter, for example, power supply level.

The terms "substantially," "close," "approximately," "near," and "about," generally refer to being within +/- 10% of a target value. For example, unless otherwise specified in the explicit context of their use, the terms "substantially equal," "about equal" and "approximately equal" mean that there is no more than incidental variation between among things so described. In the art, such variation is typically no more than +/-10% of a predetermined target value.

It is to be understood that the terms so used are interchangeable under appropriate circumstances such that the embodiments of the invention described herein are, for example, capable of operation in other orientations than those illustrated or otherwise described herein.

Unless otherwise specified the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. It is pointed out that those elements of a figure having the same reference numbers (or names) as the elements of any other figure can operate or function in any manner similar to that described, but are not limited to such.

In addition, the various elements of combinatorial logic and sequential logic discussed in the present disclosure may pertain both to physical structures (such as AND gates, OR gates, or XOR gates), or to synthesized or otherwise optimized collections of devices implementing the logical structures that are Boolean equivalents of the logic under discussion.

Here, multiple non-silicon semiconductor material layers may be stacked within a single fin structure. The multiple non-silicon semiconductor material layers may include one or more "P-type" layers that are suitable (e.g., offer higher hole mobility than silicon) for P-type transistors. The multiple non-silicon semiconductor material layers may further include one or more one or more "N-type" layers that are suitable (e.g., offer higher electron mobility than silicon) for N-type transistors. The multiple non-silicon semiconductor material layers may further include one or more intervening layers separating the N-type from the P-type layers. The intervening layers may be at least partially sacrificial, for example to allow one or more of a gate, source, or drain to wrap completely around a channel region of one or more of the N-type and P-type transistors. The multiple non-silicon semiconductor material layers may be fabricated, at least in part, with self-aligned techniques such that a stacked CMOS device may include both a high-mobility N-type and P-type transistor with a footprint of a single transistor.

For purposes of the embodiments, the transistors in various circuits, modules, and logic blocks are Tunneling FETs (TFETs). Some transistors of various embodiments may comprise metal oxide semiconductor (MOS) transistors, which include drain, source, gate, and bulk terminals. The transistors may also include Tri-Gate and FinFET transistors, Gate All Around Cylindrical Transistors, Square Wire, or Rectangular Ribbon Transistors or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors-BJT PNP/NPN, BiCMOS, CMOS, etc., may be used for some transistors without departing from the scope of the disclosure.

In various embodiments, an IC die structure comprises a vertically stacked arrangement of a plurality of layers which each comprise respective non-linear circuit components (or "active circuit components" herein) such as transistors, diodes and/or the like. A given one such layer (referred to herein as an "active" layer) is arranged in a face-to-back configuration with at least one other such layer. In this particular context, the terms "face-to-back" and "back-to-face" are understood to be synonymous herein, unless otherwise indicated.

In some example embodiments, a first active layer of an IC die structure comprises first transistors which are each of a first transistor type, wherein first memory cells of a first memory array each comprise a respective one or more of the first transistors. By contrast, a second active layer of that same IC die structure comprises second transistors which are each of a second transistor type other than the first transistor type, wherein second memory cells of a second memory array each comprise a respective one or more of the second transistors.

Furthermore, a third active layer of the IC die structure comprises third transistors which are each of a third transistor type other than the first transistor type and/or other than the second transistor type. Sense amplifiers, driver circuits and/or other suitable circuitry (referred to as "peripheral circuitry" or "peripheral circuit logic" herein) is coupled to facilitate an accessing - e.g., a reading of data from, and/or a writing of data to - of either one of the first memory array or the second memory array. In an embodiment, such peripheral circuitry includes the third transistors - e.g., wherein some or all of the third transistors are aligned vertically with the first memory array or the second memory array. It is at least with respect to transistor type that such active layers of an IC die structure are referred to herein as being "heterogeneous".

In various embodiments, the fabrication of such an arrangement of active layers enables tight integration of memory circuit resources, while providing improved protection of one such active layer from the effects of temperature and/or other conditions during the fabrication of another such active layer.

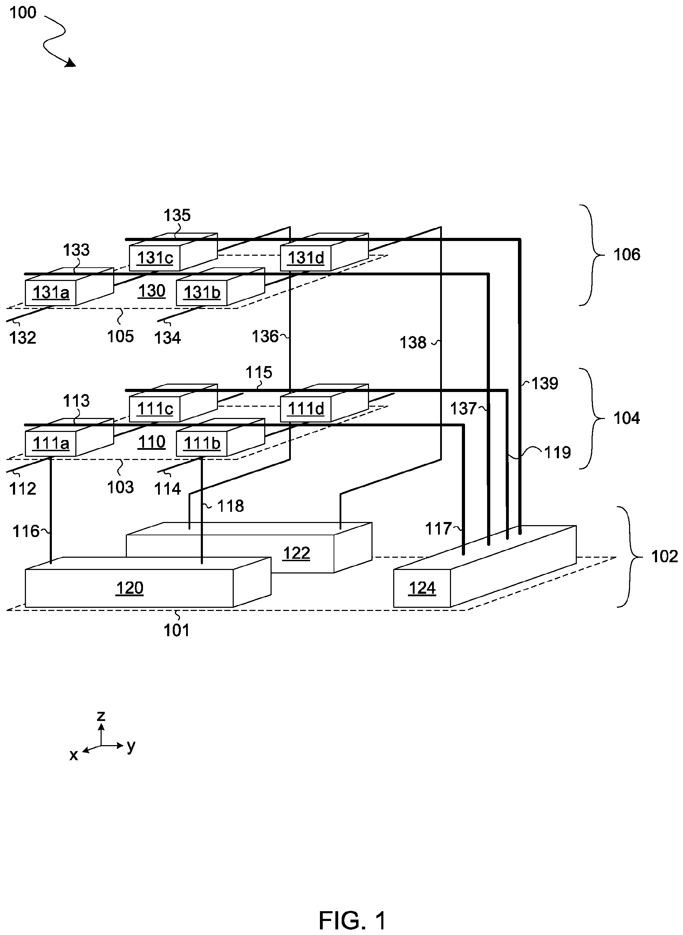

FIG. 1 shows features of an IC device 100 which comprises a vertically stacked arrangement of various types of active layers according to an embodiment. IC device 100 illustrates one example of an embodiment which comprises two or more active layers (also referred to herein as "device layers") which are coupled to each other to form one or more face-to-back configurations, wherein circuit elements - e.g., transistors - of a first such active layer are of a different type than circuit elements of another such active layer.

In the example embodiment shown, IC device 100 comprises three active layers 102, 104, 106. However, other embodiments include a vertically stacked arrangement of only two active layers, or of more than three active layers (at least two of which are heterogeneous with respect to each other). To illustrate certain features of various embodiments, IC device 100 is described herein with respect to one active layer providing memory cells of a memory array, wherein another active layer provides circuitry (variously referred to as "peripheral circuitry" or "access circuitry") with which the memory cells are to be accessed. However, other embodiments are not limited with respect to a particular functionality which is provided with any one active layer in a vertically stacked arrangement of heterogeneous active layers.

As shown in FIG. 1, active layers 104, 106 of IC device 100 variously comprise memory cells of different respective memory arrays 110, 130, which are arranged in multiple array levels comprising a first level and a second level over the first level. Active layer 102 comprises peripheral circuitry at a FEOL of IC device 100 - e.g., wherein the peripheral circuitry is to variously provide access to one or both of memory arrays 110, 130. In the example embodiment shown, such peripheral circuitry comprises word line driver circuits 120, 122 to variously access memory arrays of different respective array levels of a BEOL. In some embodiments, the peripheral circuitry additionally or alternatively comprises one or more sense amplifiers (such as the illustrative sense amplifier circuitry 124 shown), level selection circuitry and/or other components which are formed in or on active layer 102.

For a given one of memory arrays 110, 130, respective bit lines and respective word lines variously facilitate access to the memory cells thereof. A given bit line extends along a corresponding column, and across rows, of the given memory array, wherein a given word line extends along a corresponding row, and across columns, of that given memory array. In various embodiments illustrated herein, a given column of a memory array (and a corresponding bit line to access said column) extends in a direction along the y-axis shown, whereas a given row of the memory array (and a corresponding word line to access said row) extends in another direction along the x-axis shown.

In the illustrative embodiment shown, array 110 comprises memory cells 111a through 111d (referred to collectively as memory cells 111). For example, a first column of array 110 comprises cells 111a, 111b, and a second column of array 110 comprises cells 111c, 111d, wherein the first column and the second column are accessed with bit lines 113, 115 (respectively). Furthermore, a first row of array 110 comprises cells 111a, 111c, and a second row of array 110 comprises cells 111b, 111d, wherein the first row and the second row are accessed with word lines 112, 114 (respectively). Although a simplified 2x2 memory array 110 is shown for illustrative purposes, array 110 is to typically further comprise one or more other rows (not shown) which, for example, are between the first row and the second row. Additionally or alternatively, array 110 further comprises one or more other columns (not shown) which, for example, are between the first column and the second column.

Memory array 110 extends in an array area 103 (for brevity, sometimes referred to herein simply as an "area") of a horizontal (x-y) plane - e.g., wherein area 103 is defined by a maximum horizontal range of memory cells 111. In an embodiment, first sides of area 103 (the first sides opposite each other) are formed by different respective ones of an upper most row of array 110 or a lower most row of array 110. Furthermore, second sides of area 103 (the second sides opposite each other) are formed by different respective ones of a leftmost column of array 110 or a rightmost column of array 110. Accordingly, memory array 110 corresponds to a respective footprint region (or simply "footprint") which is vertically under the array area 103, and which is defined by a periphery of area 103. In an embodiment, the footprint region for array 110 comprises a horizontal footprint area which (for example) is in active layer 102.

Similarly, array 130 comprises memory cells 131a through 131d (referred to collectively as memory cells 131). Bit lines 133, 135 enable access to respective columns of memory cells 131 - e.g., wherein bit lines 133, 135 provide functionality similar to that of bit lines 113, 115. Furthermore, word lines 132, 134 are to enable access to respective rows of memory cells 131 - e.g., wherein word lines 132, 134 provide functionality similar to that of word lines 112, 114. An array area 105 for memory array 130 is defined (for example) by a horizontal range of memory cells 131, wherein a periphery of area 105 defines a respective footprint region under memory array 130. Similar to array 110, the footprint region for array 130 comprises a horizontal footprint area which is in active layer 102 - e.g., wherein respective horizontal footprint areas for memory arrays 110, 130 overlap each other.

In an illustrative scenario according to one embodiment, sense amplifier circuitry 124 is variously coupled to bit lines 113, 115, 133, 135 by interconnect structures (e.g., including the respective interconnect structures 117, 119, 137, 139 shown) to facilitate a selective reading of data from either of memory arrays 110, 130. Furthermore, word line driver circuit 120 and word line driver circuit 122 are variously coupled to word lines 112, 114, 132, 134 - e.g., via the respective interconnect structures 116, 118, 136, 138 shown - to facilitate a selective writing of data to either of memory arrays 110, 130. In various embodiments, at least one interconnect structure is shared for connection between active layer 102 and both array 110 and array 130 - e.g., wherein interconnect structure 136 instead comprises at least a portion of interconnect structure 116, wherein interconnect structure 137 instead comprises at least a portion of interconnect structure 117, and/or the like. Although some embodiments are not limited in this regard, word line driver circuit 120, word line driver circuit 122, and sense amplifier circuitry 124 are in a footprint area 101, at least a portion of which is vertically aligned with (e.g., under) some or all of area 103 and/or some or all of area 105.

In some embodiments, active layer 102 comprises a first substrate of a first bulk semiconductor material, wherein word line driver circuit 120, word line driver circuit 122, sense amplifier circuitry 124 and/or other circuits of active layer 102 comprise first transistors variously formed in or on the first bulk semiconductor material. In one such embodiment, IC device 100 further comprises a first one or more metallization layers which are arranged vertically between active layer 102 and active layer 104 - e.g., wherein portions of the first transistors are between the first bulk semiconductor material and the first one or more metallization layers.

Similarly, active layer 104 comprises a second substrate of a second bulk semiconductor material, wherein memory cells 111 and/or other circuits of active layer 104 comprise second transistors which are variously formed in or on the second bulk semiconductor material. For example, the second bulk semiconductor material is substantially the same as the first bulk semiconductor material, although some embodiments are not limited in this regard. In one such embodiment, IC device 100 further comprises a second one or more metallization layers between active layer 104 and active layer 106 - e.g., wherein portions of the second transistors are between the second bulk semiconductor material and the second one or more metallization layers.

In an embodiment, a first combination of active layer 102 and the one or more first metallization layers is bonded or otherwise coupled to a second combination of active layer 104 and the one or more second metallization layers. For example, the first combination and the second combination are coupled in a first face-to-back arrangement with each other - e.g., wherein a face of the second combination comprises the second substrate of active layer 104, and a back of the first combination comprises the one or more first metallization layers.

In some embodiments, wherein IC device 100 further comprises a third (or more) active layers, active layer 106 (for example) includes a third substrate of a third bulk semiconductor material, wherein memory cells 131 and/or other circuits of active layer 106 comprise third transistors variously formed in or on the third bulk semiconductor material. For example, the third bulk semiconductor material is substantially the same as one of the first or the second bulk semiconductor materials, although some embodiments are not limited in this regard. In one such embodiment, IC device 100 further comprises a third one or more metallization layers which are on active layer 106 - e.g., wherein portions of the third transistors are between the third bulk semiconductor material and the third one or more metallization layers. In an embodiment, a second combination of active layer 104 and the one or more second metallization layers are bonded or otherwise coupled to a third combination of active layer 106 and the one or more third metallization layers in a second face-to-back configuration. For example, a face of the third combination comprises the third substrate of active layer 106, wherein a back of the second combination comprises the one or more second metallization layers.

In some embodiments, two or more of the vertically stacked active layers of IC device 100 are each of a different respective active layer type - e.g., wherein two or more active layer types each include or otherwise correspond to a different respective transistor type. For example, the two or more active layer types comprise different respective field effect transistor (FET) types, such as different respective bulk metal oxide field effect transistor (MOSFET) types.

By way of illustration and not limitation, active layer 102 is of a first active layer type, wherein first transistors (for example, all transistors) of active layer 102 are bulk MOSFETs each of a first transistor type. By contrast, active layer 104 is of a second active layer type other than the first active layer type, wherein second transistors (for example, all transistors) of active layer 102 are bulk MOSFETs each of a second transistor type. In one such embodiment, active layer 102 omits any transistors of the second transistor type - e.g., wherein active layer 104 omits any transistors of the first transistor type.

In one such embodiment, wherein IC device 100 further comprises one or more additional active layers, one such additional active layer - e.g., active layer 106 - is of a third active layer type other than one or both of the first and second active layer types. For example, third transistors (for example, all transistors) of active layer 106 are bulk MOSFETs each of a third transistor type. In various embodiments, layer 106 omits any transistors of either the first transistor type or the second transistor type - e.g., wherein active layer 102 omits any transistors of either the second transistor type or the third transistor type, and/or wherein active layer 104 omits any transistors of either the first transistor type or the third transistor type.

In an illustrative scenario according to one embodiment, a given transistor type includes or otherwise corresponds to particular one of various transistor topologies - e.g., the various transistor topologies comprising one or more single gate transistor topologies, one or more multi-gate transistor topologies, a recessed gate topology, a recessed gate topology, and/or the like. For example, such one or more single gate transistor topologies comprise a planar transistor topology. Alternatively or in addition, such one or more multi-gate topologies comprise one or more gate-all-around transistor topologies (e.g., including a nanoribbon topology, a nanowire topology, and/or the like), one or more tri-gate transistor topologies, and/or the like.

In various embodiments, a given transistor type additionally or alternatively includes, or otherwise corresponds to, particular one of various possible channel lengths (various average channel lengths, for example), or a particular one of various ranges of possible channel lengths. By way of illustration and not limitation, transistors of one transistor type have respective channel structures, the lengths of which are each in a particular range of possible lengths - e.g., wherein transistors of another transistor type have respective channel structures, the lengths of which are each is in a different range of lengths. In one such embodiment, two such ranges include respective lengths which correspond to each other - e.g., respective minimum lengths of the ranges, or respective maximum lengths of the ranges, or respective average lengths of the ranges - and which differ by at least 5%. For example, a first average channel length, of a first range of possible lengths, is at least 105% (or alternatively, is not more than 95%) of a second average channel length of a second range of possible lengths.

In various embodiments, a given transistor type additionally or alternatively includes, or otherwise corresponds to, a particular one of various semiconductor material types - e.g., including a silicon germanium (SiGe) material type, any of various oxide semiconductor material types, and/or the like.

In various embodiments, a given transistor type additionally or alternatively includes, or otherwise corresponds to, particular one of various possible switching speeds (various average switching speeds, for example), or a particular one of various ranges of possible switching speeds. A metric of a given switching speed includes or is otherwise based on a period of time needed for a transistor to transition between an active ("ON") state and an inactive ("OFF") state. In an embodiment, such a metric represents a number of state transitions which can be performed by a transistor in a particular period of time.

By way of illustration and not limitation, transistors of one transistor type exhibit respective switching speeds which are each in a particular range of possible switching speeds - e.g., wherein transistors of another transistor type exhibit switching speeds of which are each is in a different range of switching speeds. In one such embodiment, two such ranges include respective switching speeds which correspond to each other - e.g., respective minimum switching speeds of the ranges, or respective maximum switching speeds of the ranges, or respective average switching speeds of the ranges - and which differ by at least 10%. For example, a first average switching speed, of a first range of possible switching speeds, is at least 110% (or alternatively, is not more than 90%) of a second average switching speed of a second range of possible switching speeds.

In some embodiments, vertically stacked active layers of IC device 100 correspond to different respective transistor types which, for example, are each exclusive of (that is, which each omit, or are otherwise agnostic with respect to) any particular type of doping - e.g., dopant type and/or dopant concentration - of a semiconductor material. Additionally or alternatively, such different respective transistor types are bulk MOSFET transistor types (e.g., rather than types of thin film transistors), in some embodiments.

In some embodiments, wherein an IC device comprises memory arrays which are arranged in multiple array levels, one such memory array comprises memory cells which are of a first cell type, wherein another memory array comprises memory cells which are of a second cell type other than the first cell type. By way of illustration and not limitation, in one such embodiment, memory cells 111 (for example) are of a first one of multiple memory cell types, wherein memory cells 131 are of a different one of the multiple memory cell types. In one such embodiment, the multiple memory cell types comprise one or more dynamic RAM (DRAM) cell types, and one or more static RAM (SRAM) cell types. Alternatively or in addition, the multiple memory cell types comprise (for example) one or more 2D memory cell types, and/or one or more 3D memory cell types.

In some embodiments, the multiple memory cell types comprise multiple DRAM cell types which (for example) each correspond to a different respective combination of one or more transistors and one or more capacitors in a given cell. Some or all of the multiple DRAM cell types each correspond to a different respective type of capacitor(s) in a given cell, in one such embodiment. In some embodiments, the multiple memory cell types additionally or alternatively comprise multiple SRAM cell types which (for example) each correspond to a different respective total number of transistors in a given cell, to a different respective total number of transistor types in a given cell, and/or the like.

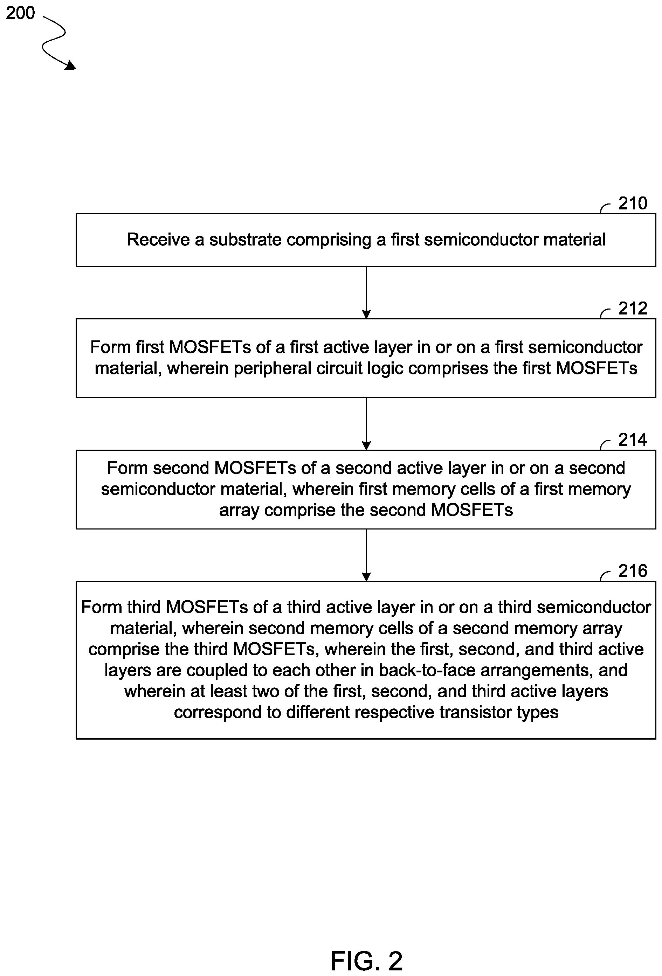

FIG. 2 shows features of a method 200 to fabricate an integrated circuit die structure comprising a vertical arrangement of heterogeneous memory arrays according to an embodiment. Method 200 illustrates one example of an embodiment which fabricates structures of an IC die to provide multiple active layers which correspond to different respective transistor types, wherein said active layers are vertically arranged in various respective back-to-face configurations with each other. Operations such as those of method 200 are performed, for example, to provide some or all structures of IC device 100.

As shown in FIG. 2, method 200 comprises (at 210) receiving a substrate comprising a first semiconductor material. By way of illustration and not limitation, the first semiconductor material comprises a monocrystalline semiconductor material such as, but not limited to, predominantly silicon (e.g., substantially pure Si) material, predominantly germanium (e.g., substantially pure Ge) material, or a compound material comprising a Group IV majority constituent (e.g., SiGe alloys, GeSn alloys). In various embodiments, the first semiconductor material is a Group III-N material comprising a Group III majority constituent and nitrogen as a majority constituent (e.g., GaN, InGaN). In another embodiment, the first semiconductor material is a Group III-V material comprising a Group III majority constituent and a Group IV majority constituent (e.g., InGaAs, GaAs, GaSb, InGaSb).

Method 200 further comprises (at 212) forming, in or on a first semiconductor material, first MOSFETs of a first active layer. For example, the forming at 212 includes any of various suitable semiconductor fabrication processes to provide complementary metal oxide semiconductor (CMOS) and/or other types of front-end-of-line circuitry. In one such embodiment, said circuitry comprises peripheral circuit logic which is to subsequently facilitate access to any of multiple memory arrays. By way of illustration and not limitation, such peripheral circuit logic comprises any of various suitable combinations of sense amplifier circuitry and/or driver circuitry. In some embodiments, the forming at 212 further provides transistors of host integrated circuitry, such as those of one or more memory controller circuits, those of one or more processor core circuits, and/or the like.

In some embodiments, the forming at 212 includes, or (for example) is followed by, one or more operations to form first metallization layers on the first MOSFETs. For example, such one or more operations comprise forming one or more initial levels of patterned interconnect metallization structures which are variously embedded in, or otherwise insulated at least partially with, dielectric material structures. In an embodiment, such one or more operations are adapted from conventional metallization techniques - e.g., wherein the patterned interconnect metallization structures at least partially enable the peripheral circuit logic to be subsequently coupled to two or more memory arrays.

Method 200 further comprises (at 214) forming second MOSFETs of a second active layer in or on a second semiconductor material. For example, the second semiconductor material is the same as the first semiconductor material, although some embodiments are not limited in this regard. The first MOSFETs formed at 212 are of a first transistor type which, for example, is different than a second transistor type of the second MOSFETs.

In an embodiment, the first active layer and the second active layer are coupled to each other in a first back-to-face arrangement. For example, at 214, respective structures of the second MOSFETs are variously formed in or on a substrate of the second semiconductor material, after which the first metallization layers are disposed under the substrate, between the first active layer and the second active layer.

In one such embodiment, the forming at 214 comprises depositing the second semiconductor material on the first metallization layers - e.g., wherein said depositing is adapted from any of various suitable semiconductor layer transfer techniques. After such depositing, one or more patterned mask, etch, deposition, and/or other suitable semiconductor fabrication operations are performed to form the second MOSFETs on the deposited substrate.

In another such embodiment, the forming at 214 comprises fabricating the second MOSFETs in or on the second semiconductor material prior to a coupling of the second active layer to the first active layer (e.g., via the first metallization layers). For example, a hybrid bond (or other) assembly process is performed to couple a combination of both the second MOSFETs and the second semiconductor material to the first active layer (e.g., via the first metallization layer). As a result, hybrid bond structures are disposed between the first metallization layers and a substrate of the second semiconductor material.

In an embodiment, a first memory array comprises first memory cells which each comprise a respective one or more of the second MOSFETs. In one such embodiment, some or all of the first metallization layers variously couple the peripheral circuit logic (which comprises the first MOSFETs) to the first memory cells.

In some embodiments, the forming at 214 includes, or (for example) is followed by, one or more operations to form second metallization layers on the second MOSFETs. For example, the second metallization layers - e.g., in combination with the first metallization layers - at least partially enable the peripheral circuit logic to be further coupled to another one or more memory arrays. In an embodiment, such one or more operations are adapted from conventional metallization techniques.

Method 200 further comprises (at 216) forming third MOSFETs of a third active layer in or on a third semiconductor material. For example, the third semiconductor material is the same as one (or both) of the first semiconductor material or the second semiconductor material, although some embodiments are not limited in this regard. The third MOSFETs formed at 216 are of a third transistor type which, for example, is different than a transistor type of the first MOSFETs, and/or a transistor type of the second MOSFETs.

In an embodiment, the second active layer and the third active layer are coupled to each other in a second back-to-face arrangement. For example, at 216, respective structures of the third MOSFETs are variously formed in or on a substrate of the third semiconductor material, after which the second metallization layers are disposed under the substrate, between the second active layer and the third active layer.

In one such embodiment, the forming at 216 comprises depositing the substrate of the third semiconductor material on the second metallization layers - e.g., wherein said depositing is adapted from any of various suitable semiconductor layer transfer techniques. After such depositing, one or more patterned mask, etch, deposition, and/or other suitable semiconductor fabrication operations are performed to form the third MOSFETs on the deposited substrate.

In another such embodiment, the forming at 216 comprises fabricating the third MOSFETs in or on the third semiconductor material prior to a coupling of the third active layer to the second active layer (e.g., via the second metallization layers). For example, a hybrid bond (or other) assembly process is performed to couple a combination of both the third MOSFETs and the third semiconductor material to the second active layer (e.g., via the second metallization layer). As a result, hybrid bond structures are disposed between the second metallization layers and the third semiconductor material.

In an embodiment, a second memory array comprises second memory cells which each comprise a respective one or more of the third MOSFETs. In one such embodiment, some or all of the second metallization layers variously couple the peripheral circuit logic (which comprises the second MOSFETs) to the second memory cells.

In some embodiments, the forming at 216 includes, or (for example) is followed by, one or more operations to form third metallization layers on the third MOSFETs. For example, the third metallization layers - e.g., in combination with the first metallization layers and the second metallization layers - at least partially enable the peripheral circuit logic to be further coupled to the second memory array.

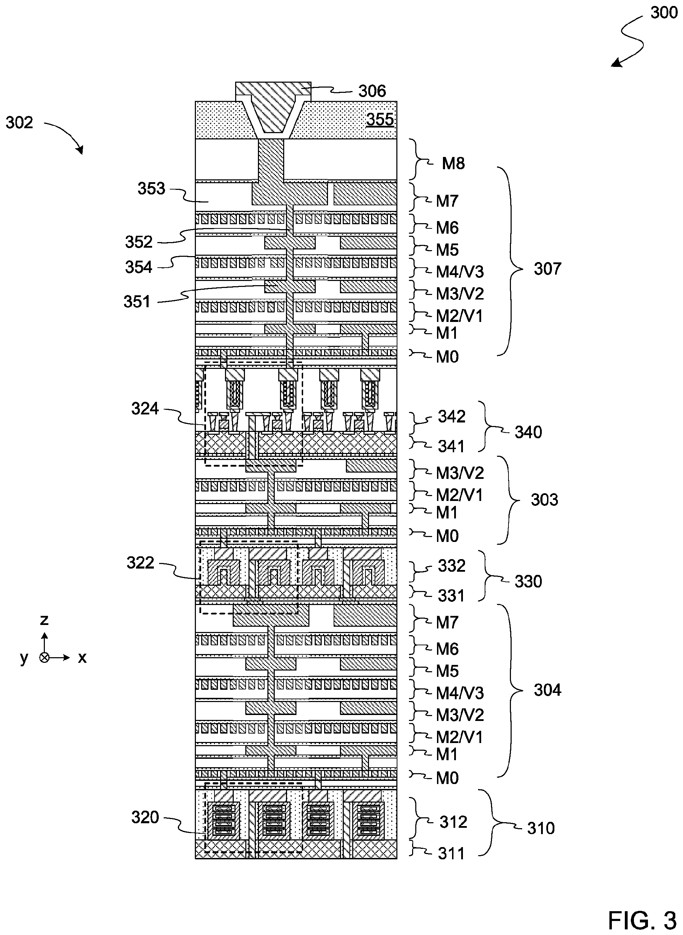

FIG. 3 shows features of an IC system 300 comprising a vertically stacked arrangement of memory arrays and peripheral circuitry according to an embodiment. In various embodiments, IC system 300 provides functionality such as that of IC device 100 - e.g., wherein structures of IC system 300 are provided by one or more operations of method 200.

As shown in FIG. 3, IC system 300 comprises lateral surfaces each along a respective x-y plane that may be defined or taken at any vertical position of IC system 300. The lateral surface of the *x-y* plane is orthogonal to a vertical or build-up dimension as defined by the z-axis. In some embodiments, IC system 300 may be formed from any of various substrate materials (e.g., comprising the illustrative semiconductor layer 311 shown) which are suitable for the fabrication of transistor circuitry. In some embodiments, a semiconductor layer 311 is used to manufacture transistors 312 (i.e., MOSFETs) and other transistors and components of IC system 300. The semiconductor layer 311 may include that of a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as gallium arsenide. The substrate may also include semiconductor materials, metals, dielectrics, dopants, and other materials commonly found in semiconductor substrates.

In FIG. 3, IC system 300 includes an IC die 302, which is a monolithic IC structure comprising multiple heterogeneous active layers which are stacked in various respective back-to-front arrangements with each other. In an embodiment, the monolithic IC structure of IC die 302 further comprises metallization layers which are variously disposed each between a respective two of the active layers, or (for example) on a topmost one of the active layers.

In the example embodiment shown, an active layer 310 of IC die 302 comprises semiconductor layer 311 and transistors 312 which are variously formed in or on semiconductor layer 311. Some or all of transistors 312 are each of a first transistor type which, for example, comprises a gate-all-around transistor topology type (in this example, a nanoribbon transistor type). For example, such transistors 312 are those of peripheral circuit logic (e.g., comprising sense amplifiers, driver circuits, or the like) which facilitate access to various memory arrays of IC die 302. For example, active layer 310 provides functionality such as that of active layer 102 - e.g., wherein transistors 312 provide functionality of word line driver circuit 120, word line driver circuit 122, sense amplifier circuitry 124 or other such circuitry.

In an embodiment, IC die 302 further comprises metallization layers 304 which are disposed on a back side of active layer 310. As used herein, the term "metallization layer" describes layers with interconnections or wires that provide electrical routing, generally formed of metal or other electrically and thermally conductive material. In IC die 302, adjacent metallization layers may be formed of different materials and by different methods. Adjacent metallization layers, such as metallization interconnects 351, are interconnected by vias, such as vias 352, that may be characterized as part of the metallization layers or between the metallization layers. As shown, in some embodiments, metallization layers 304 are formed over and immediately adjacent transistors 312. In the illustrated example, metallization layers 304 include M0, V0, M1, M2/V1, M3/V2, M4/V3, and M5-M7. However, metallization layers 304 may include any number of metallization layers such as eight or more metallization layers.

In one such embodiment, another active layer 330 of IC die 302 comprises a semiconductor layer 331 and transistors 332 (i.e., MOSFETs) which are variously formed in or on semiconductor layer 331. Some or all of transistors 332 are each of a second transistor type other than the first transistor type - e.g., wherein the second transistor type comprises the illustrative tri-gate transistor topology type shown. In various embodiments, a first memory array of IC die 302 comprises first memory cells (SRAM cells, for example) which variously comprise respective ones of transistors 332. For example, active layer 330 provides functionality such as that of active layer 104 - e.g., wherein transistors 332 are each of a respective one of memory cells 111. By way of illustration and not limitation, a given one of the first memory cells is a four transistor (4T) SRAM cell, a six transistor (6T) SRAM cell, or the like.

Active layers 310, 330 are vertically stacked in a first back-to-face arrangement relative to each other - e.g., wherein metallization layers 304 and a portion of semiconductor layer 331 are disposed between transistors 332 and active layer 310.

In some embodiments, IC die 302 further comprises additional metallization layers 303 which are disposed on a back side of active layer 330. In the illustrated example, metallization layers 303 include M0, M1, M2/V1, and M3/V2. However, metallization layers 303 may include any number of metallization layers such as four or more metallization layers.

Furthermore, another active layer 340 of IC die 302 comprises a semiconductor layer 341 and transistors 342 (i.e., MOSFETs) which are variously formed in or on semiconductor layer 341. Some or all of transistors 342 are each of a third transistor type - e.g., other than the first transistor type corresponding to active layer 310 and/or other than the second transistor type corresponding to active layer 330. In the example embodiment shown, the third transistor type comprises a planar transistor topology type. In various embodiments, a second memory array of IC die 302 comprises second memory cells (DRAM cells, for example) which variously comprise respective ones of transistors 342. For example, active layer 340 provides functionality such as that of active layer 106 - e.g., wherein transistors 342 are each of a respective one of memory cells 131. By way of illustration and not limitation, a given one of the second memory cells one transistor, n capacitor (1T-nC) DRAM cell, where *n* is a positive integer.

In an embodiment, active layers 330, 340 are vertically stacked in a second back-to-face arrangement relative to each other - e.g., wherein metallization layers 303 and a portion of semiconductor layer 341 are disposed between transistors 342 and active layer 330. In some embodiments, IC die 302 further comprises further comprises metallization layers 307 which are disposed on a back side of active layer 340. In the illustrated example, metallization layers 307 include M0, M1, M2/V1, M3/V2, M4/V3, and M5-M8. However, metallization layers 307 may include any number of metallization layers such as eight or more metallization layers.

Metallization layers 304, 303, 307 are embedded within dielectric materials 353, 354. In the example of FIG. 3, package-level interconnects 306 are provided on or over a back of IC die 302 - e.g., as bumps over a passivation layer 355. In some embodiments, IC system 300 is attached to a circuit board, a substrate, or any of various other suitable devices (not shown) by package-level interconnects 306. However, package-level interconnects 306 may be provided using any suitable interconnect structures such as bond pads, solder bumps, etc. Interconnectivity of some or all of transistors 312, 332, 342 (and other transistors, etc.), signal routing in a separation layer between channel stack structures, and routing to an outside device (not shown), is variously provided with some or all of metallization layers 304, metallization layers 303, metallization layers 307, and package-level interconnects 306.

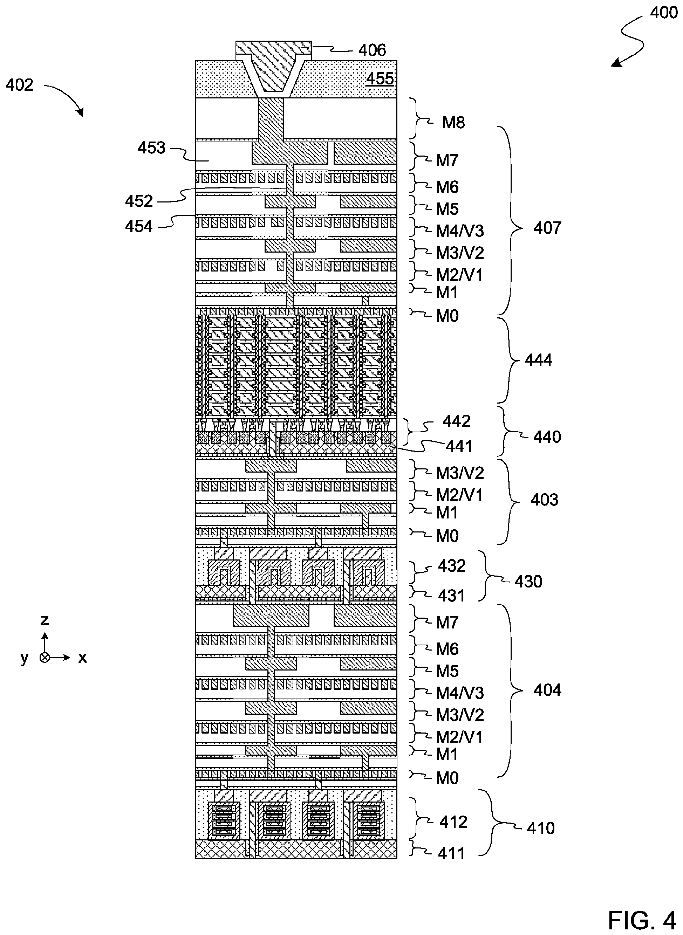

FIG. 4 shows features of an IC system 400 comprising memory arrays arranged over corresponding peripheral circuitry according to another embodiment. In various embodiments, IC system 400 provides functionality such as that of IC device 100 or IC system 300 - e.g., wherein structures of IC system 300 are provided by one or more operations of method 200.

As shown in FIG. 4, IC system 400 comprises an IC die 402, which is a monolithic IC structure comprising multiple heterogeneous active layers which are stacked in various respective back-to-front arrangements with each other. In an embodiment, the monolithic IC structure of IC die 402 further comprises metallization layers which are variously disposed each between a respective two of the active layers, or (for example) on a topmost one of the active layers.

In the example embodiment shown, IC die 402 comprises active layers 410, 430, 440 which, for example, correspond functionally to active layers 310, 330, and 340 (respectively). IC system 400 further comprises metallization layers 404 disposed between active layers 410, 430, in addition to metallization layers 403 disposed between active layers 430, 440, as well as other metallization layers 407 disposed at a back of active layer 440.

Metallization layers 404, 403, 407 are variously embedded within respective dielectric materials (for example, including the illustrative dielectric materials 453, 454 shown) - e.g., wherein adjacent metallization layers are interconnected by vias, such as vias 452. By way of illustration and not limitation, metallization layers 304 include M0, V0, M1, M2/V1, M3/V2, M4/V3, and M5-M7 - e.g., wherein metallization layers 303 include M0, M1, M2/V1, and M3/V2. Furthermore, metallization layers 307 include M0, M1, M2/V1, M3/V2, M4/V3, and M5-M8. However, IC die 302 includes any of various combinations of more or fewer metallization layers, in other embodiments.

In the example of FIG. 4, package-level interconnects 406 are provided on or over a back of IC die 402 - e.g., as bumps over a passivation layer 455. In some embodiments, IC system 400 is attached to a circuit board, a substrate, or any of various other suitable devices (not shown) by package-level interconnects 406. However, package-level interconnects 406 may be provided using any suitable interconnect structures such as bond pads, solder bumps, etc.

Interconnectivity of some or all of transistors 412, 432, 442 and/or with an outside device (not shown), is variously provided with some or all of metallization layers 404, metallization layers 403, metallization layers 407, and package-level interconnects 406. For example, metallization layers 404 correspond functionally to metallization layers 304 - e.g., wherein metallization layers 403 correspond functionally to metallization layers 303, and wherein metallization layers 407 correspond functionally to metallization layers 307.

In the example embodiment shown, active layer 410 comprises a semiconductor layer 411 and transistors 412 which are variously formed therein or thereon - e.g., wherein transistors 412 comprises features of transistors 312. Transistors 412 are of a first type (e.g., comprising a nanoribbon transistor type), wherein peripheral circuit logic, to access memory arrays of IC die 402, comprise some or all such transistors 412. Furthermore, active layer 430 comprises a semiconductor layer 431 and transistors 432 which are variously formed therein or thereon. Transistors 432 are of a second type (e.g., comprising a tri-gate transistor type), wherein a first memory array - which is to be accessed with the peripheral circuit logic - comprises some or all of the transistors 432. Further still, active layer 440 comprises a semiconductor layer 441 and transistors 442 which are variously formed therein or thereon. Transistors 442 are of a third type (e.g., comprising a planar transistor type), wherein a second memory array - which is also to be accessed with the peripheral circuit logic - comprises some or all of the transistors 442.

In the example embodiment shown, the first array comprises SRAM memory cells, and the second memory array comprises a three-dimensional (3D) memory array. By way of illustration and not limitation, the first array comprises 4T SRAM cells, 6T SRAM cell, or the like. Alternatively or in addition, the 3D memory cells are provided with transistors 442 and storage capacitors 444 which are variously coupled thereto - e.g., wherein such cells are adapted from any of various conventional 3D memory designs.

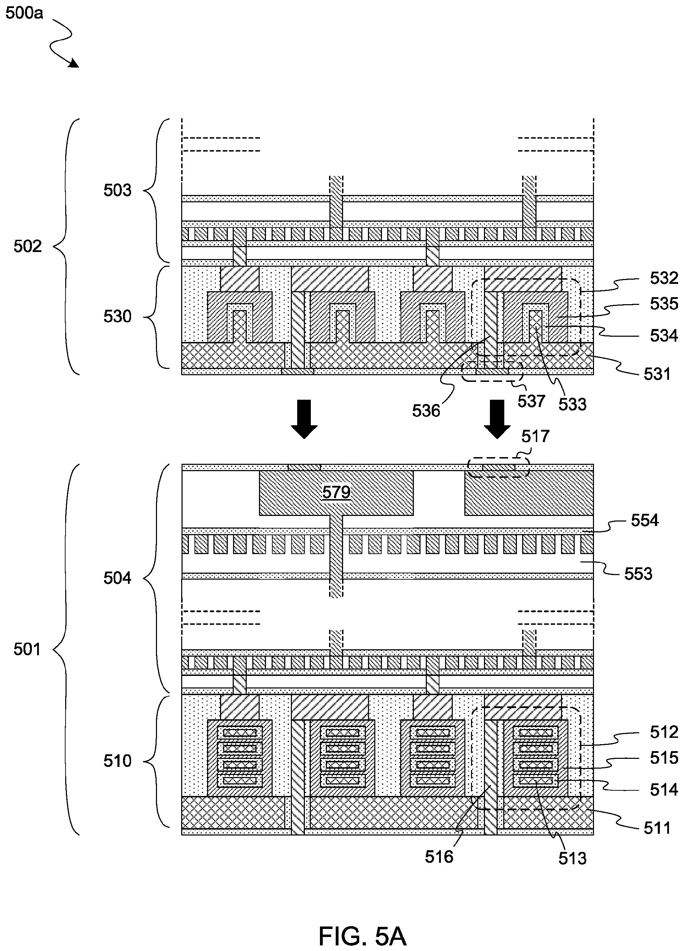

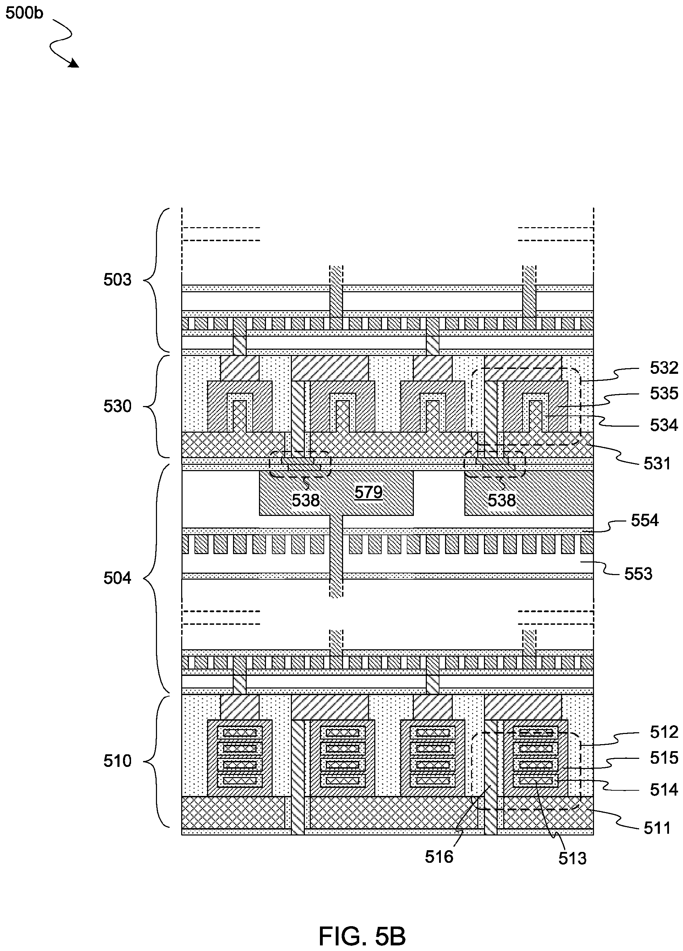

FIGs. 5A, 5B show cross-sectional side views of structures during respective stages 500a, 500b of processing to form a composite integrated circuit structure according to an embodiment. Processing such as that illustrated by stages 500a, 500b provides structures such as some or all of those of IC device 100, IC system 300, or IC system 400 - e.g., wherein said processing includes one or more operations of method 200.

Referring now to FIG. 5A, at stage 500a, a sub-assembly 502 is oriented, aligned or otherwise positioned to facilitate coupling with another sub-assembly 501. Sub-assembly 501 comprises a vertically stacked arrangement of an active layer 510 and metallization layers 504 which, for example, correspond to active layer 310 and metallization layers 304 (respectively).

Active layer 510 comprises a semiconductor layer 511 and first MOSFETs - in this example, comprising the illustrative transistor 512 shown - which are each of a first transistor type. In the example embodiment shown, the first MOSFETs are of a nanoribbon (or other gate-all-around) transistor type. For example, transistor 512 comprises nanoribbon structures (e.g., including the illustrative nanoribbon structure 513) which are each operable to selectively provide a respective conductive channel. Semiconductor layer 511 has formed therein or thereon source or drain structures (not shown) of transistor 512, wherein said source or drain structures are on opposite respective ends of a given nanoribbon structure 513. In an embodiment, a conduction of current in a given nanoribbon structure 513 is controlled by a voltage at a gate electrode 515 of transistor 512 - e.g., wherein a gate insulator 514 is disposed around nanoribbon structure 513 to facilitate insulation from gate electrode 515.

Metallization layers 504 comprise patterned interconnect structures 579 which are variously embedded within dielectric materials 553, 554. In an embodiment, some or all of the patterned interconnect structures 579 are to variously facilitate transistors of active layer 510 being coupled with one or more memory arrays, and/or with peripheral circuit logic which is to operate multiple memory arrays. Although some embodiments are not limited in this regard, transistor 512 is coupled to a through silicon via 516 which extends through semiconductor layer 511 to one or more front-end circuit structures (not shown).

Sub-assembly 502 comprises a vertically stacked arrangement of another active layer 530 and metallization layers 503 which, for example, correspond to active layer 330 and metallization layers 303 (respectively). Active layer 530 comprises a semiconductor layer 531 and second MOSFETs - in this example, comprising the illustrative transistor 532 shown - which are each of a second transistor type other than the first transistor type.

In the example embodiment shown, the second MOSFETs are of a tri-gate (or other FinFET) transistor type. For example, semiconductor layer 531 has formed therein or thereon doped source or drain structures (not shown) of transistor 532, wherein said source or drain structures are on opposite respective ends of a fin structure 533 of transistor 532. Fin structure 533 is operable to selectively provide a conductive channel between the source or drain structures, based on a voltage at a gate electrode 535 of transistor 532 - e.g., wherein a gate insulator 534 facilitates insulation of fin structure 533 from gate electrode 515.

Metallization layers 503 are to variously facilitate transistors of active layer 530 being coupled with a memory array, and/or with peripheral circuit logic which is to operate multiple memory arrays. Although some embodiments are not limited in this regard, transistor 532 is coupled to a through silicon via 536 which extends through semiconductor layer 531 to a contact structure 517 with which sub-assembly 502 is to be bonded to a counterpart contact structure 537 of sub-assembly 501.

At stage 500b, a hybrid bonding process has been completed to couple sub-assembly 501 with sub-assembly 502. For example, active layer 510 is coupled to active layer 530 in a back-to-face arrangement at stage 500b - e.g., wherein metallization layers 504 and a portion of semiconductor layer 531 are between active layer 510 and the second MOSFETs of active layer 530. After such coupling of sub-assemblies 501, 502, hybrid bond structures 538 are variously formed at an interface between metallization layers 504 and active layer 530 - e.g., wherein sub-assembly 501 comprises structures such as those in region 320, and wherein metallization layers 503 comprises structures such as those in region 322.

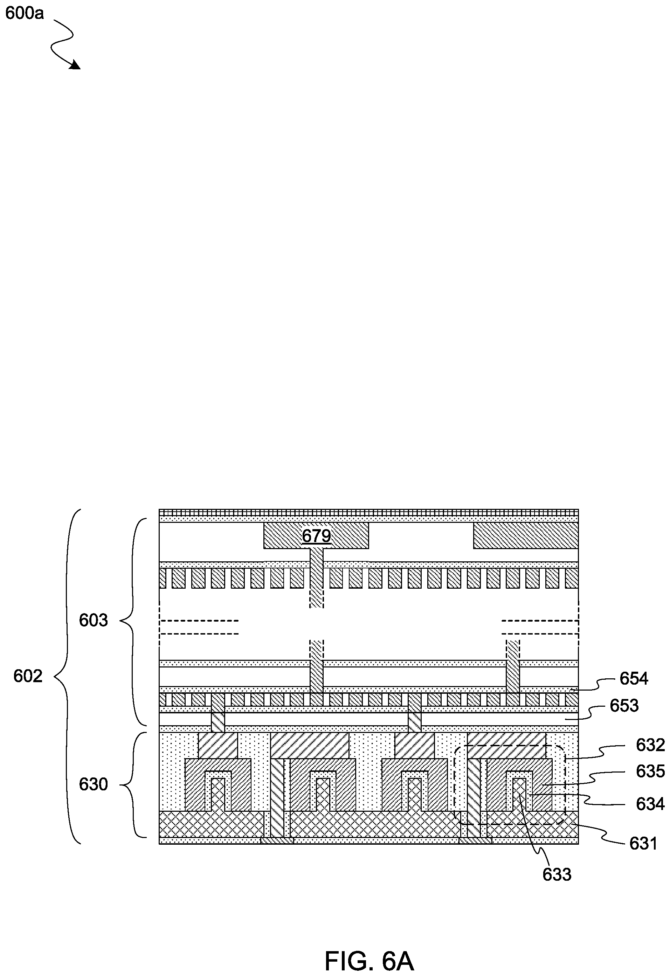

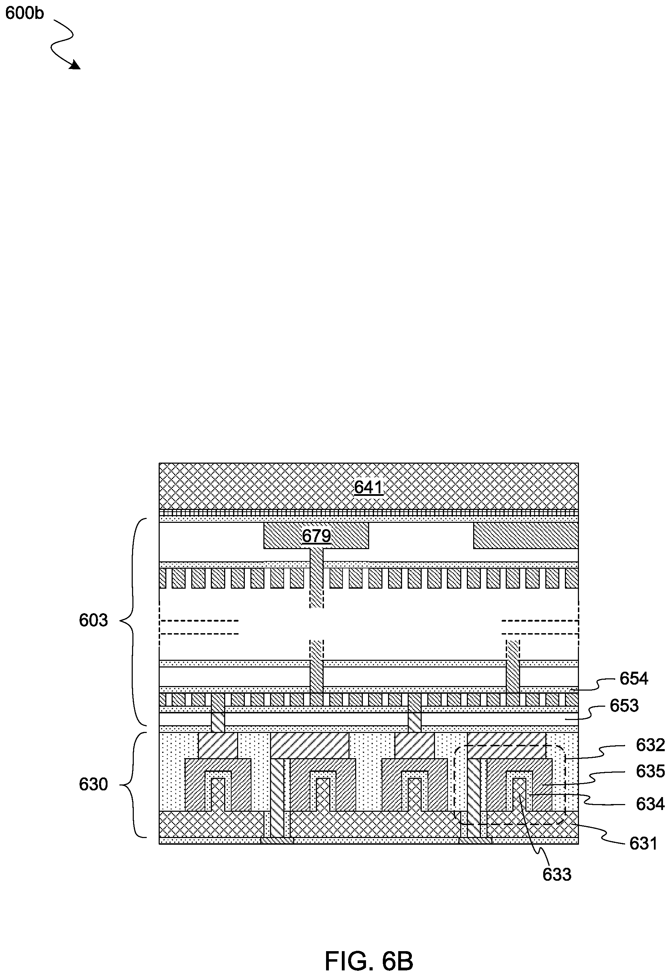

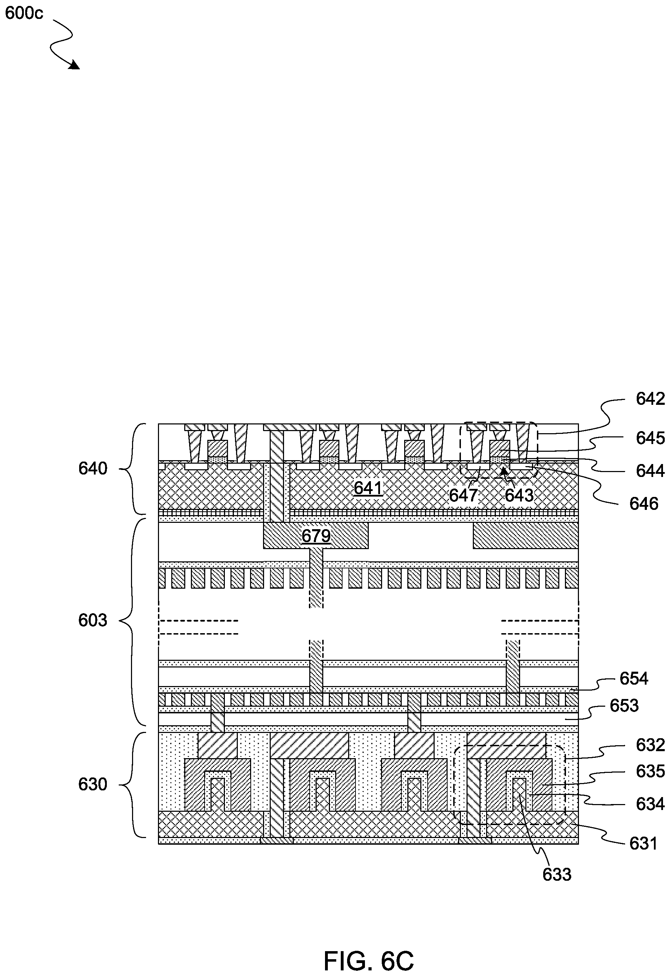

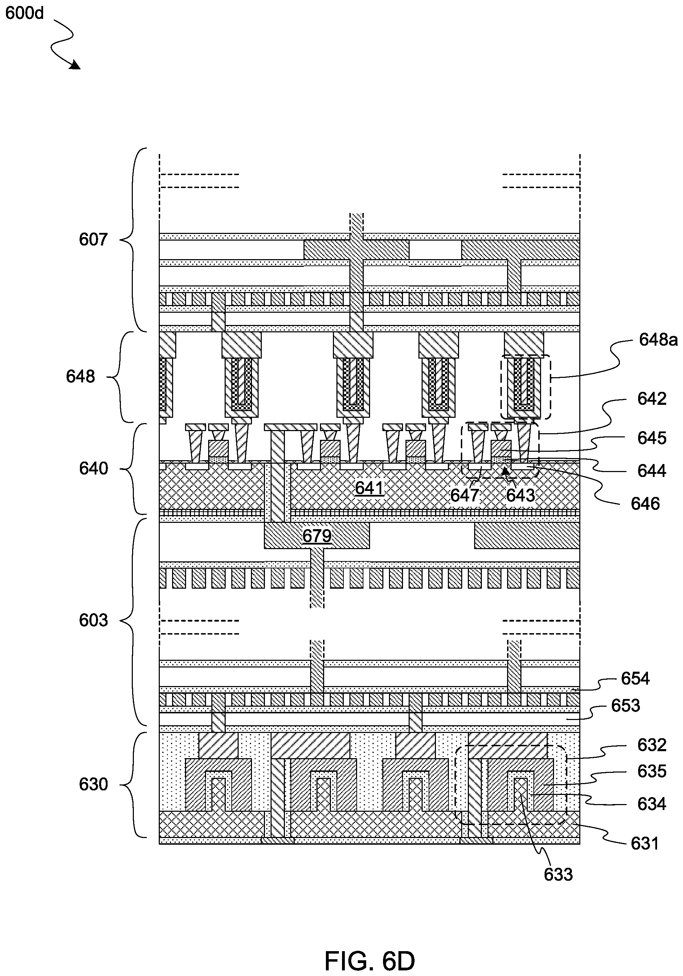

FIGs. 6A through 6D show respective stages 600a-600d of processing to manufacture an IC device comprising heterogeneous stacked memory arrays according to an embodiment. Processing such as that illustrated by stages 600a-600d provides structures such as some or all of those of IC device 100, IC system 300, or IC system 400 - e.g., wherein said processing includes one or more operations of method 200.

Referring now to FIG. 6A, at stage 600a, circuit structures 602 are fabricated or otherwise provided for inclusion in an IC die structure according to an embodiment - e.g., wherein circuit structures 602 have some or all of the features of sub-assembly 502. Circuit structures 602 comprises and active layer 630 and metallization layers 603 thereon. For example, active layer 630 and metallization layers 603 correspond functionally to active layer 530 and metallization layers 503 (respectively), in some embodiments. In various embodiments, circuit structures 602 further comprise one or more other active layers and metallization layers (not shown). In one such embodiment, circuit structures 602 further comprises active layer 510 and metallization layers 504, wherein a front side of active layer 630 is hybrid bonded to or otherwise coupled with metallization layers 504.

In the example embodiment shown, active layer 630 comprises a semiconductor layer 631 and MOSFETs which are variously formed therein or thereon. By way of illustration and not limitation, one such MOSFET of active layer 630 - transistor 632 - comprises a fin structure 633, a gate insulator 634, and a gate electrode 635 which, for example, correspond functionally to fin structure 533, gate insulator 534, and gate electrode 535 (respectively). Metallization layers 603 comprise patterned interconnect structures 679 which are variously surrounded by or otherwise at least partially insulated with dielectric material 653, dielectric material 654 - e.g., wherein patterned interconnect structures 679 provide functionality such as that of patterned interconnect structures 579.

In an embodiment, a first memory array comprises MOSFETs of active layer 630, wherein metallization layers 603 facilitate coupling within the first memory array and/or coupling of the first memory array to other circuitry. For example, interconnect structures 679 provide bit lines, word lines, and/or other interconnect structures to variously provide coupling within a cell of the first memory array, coupling between cells of the first memory array, coupling between the first memory array and peripheral circuit logic, and/or coupling between the first memory array and another memory array. In one example embodiment, the first memory array is a SRAM memory array.

At stage 600b, a semiconductor layer 641 is formed on a top surface of metallization layers 603. Semiconductor layer 641 comprises any of various suitable semiconductor materials, such as that of semiconductor layer 631, or that of another active layer (if any) of circuit structures 602. In an embodiment, formation of semiconductor layer 641 on circuit structures 602 comprises operations which, for example, are adapted from any of various conventional semiconductor layer transfer techniques. Some embodiments are not limited with respect to such techniques, which are not detailed herein to avoid obscuring features of said embodiments.

At stage 600c, additional semiconductor fabrication processes have been performed to provide an active layer 640 which includes transistor structures variously formed in or on semiconductor layer 641. In some embodiments, MOSFETs of active layer 640 are of a different transistor type than that of transistor 632 (and/or of one or more other transistors of active layer 630). In the example embodiment shown, transistor 632 is of a nonplaner transistor type (more particularly, a tri-gate transistor type), whereas a transistor 642 of active layer 640 is of a planar transistor type.

For example, transistor 642 comprises a channel region 643 a gate insulator 644, a gate electrode 645 which, for example, correspond functionally to fin structure 533, gate insulator 534, and gate electrode 535 (respectively). Channel region 643 is operable to selectively conduct current between source or drain regions 646, 647 of transistor 642 based on a voltage at gate electrode 645. In an embodiment, active layer 630 is coupled to active layer 640 in a back-to-face arrangement at stage 600c - e.g., wherein metallization layers 603 and a portion of semiconductor layer 641 are between active layer 630 and the second MOSFETs of active layer 640.

At stage 600d, other fabrication processes have been performed to provide additional integrated circuit structures on active layer 640. For example, such additional integrated circuit structures comprise storage capacitors 648 of a memory array which also includes some or all of the MOSFETs of active layer 640. In an embodiment, region 324 of IC die 302 (for example) comprises structures of active layer 640 and structures of the storage capacitors 648. Furthermore, the additional processing forms metallization layers 607 on the storage capacitors 648. In the example embodiment shown, a memory cell of the memory array comprises transistor 632 and a storage capacitor 648a - e.g., wherein the memory cell is adapted from any of various existing DRAM cell designs.

In an embodiment, metallization layers 607 provide bit lines, word lines, and/or other interconnect structures to variously provide coupling within a cell of the memory array, coupling between cells of the memory array, coupling between the memory array and peripheral circuit logic, and/or coupling between the memory array and another memory array.

In various embodiments, fabrication such as that illustrated by stages 600a through 600d is preceded by hybrid bonding and/or other fabrication processes, such as those illustrated by stages 500a, 500b. In an alternative embodiment, such hybrid bonding and/or other fabrication processes take place after stage 600d. The ordering of such stages of processing is determined, for example, based on different respective transistor types to which active layers variously correspond. By way of illustration and not limitation, such ordering is selected based on whether a first active layer would be more tolerant of a subsequent fabrication of a second active layer - e.g., as compared to the second active layer's tolerance of a subsequent fabrication of the first active layer. In an embodiment, the second active layer is fabricated after the first active layer, and/or the second active layer is fabricated separately from the first active layer, and subsequently bonded or otherwise coupled to the first active layer.

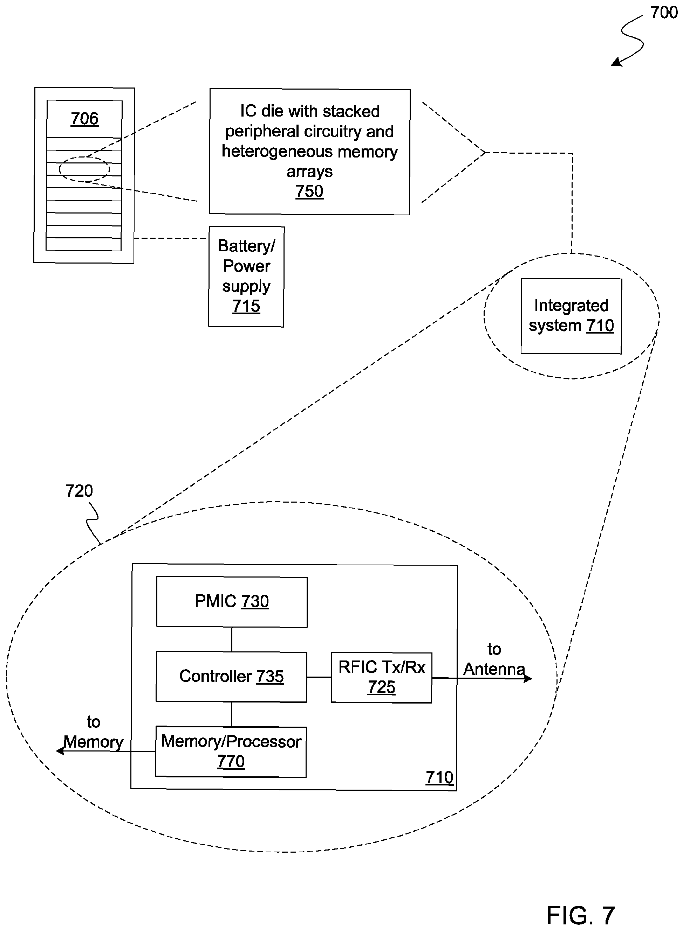

FIG. 7 illustrates a schematic of a data server machine 700 including an IC device which comprises heterogeneous memory arrays and peripheral circuitry which are vertically stacked in various back-to-face arrangements, in accordance with one or more embodiments described elsewhere herein. Server machine 706 may be any commercial server, for example, including any number of high-performance computing platforms disposed within a rack and networked together for electronic data processing, which in the exemplary embodiment includes one or more devices 750, an IC die of which comprises a stacked arrangement of peripheral circuitry and heterogeneous memory arrays.

Also as shown, server machine 706 includes a battery and/or power supply 715 to provide power to devices 750, and to provide, in some embodiments power delivery functions such as power regulation. Devices 750 may be deployed as part of a package-level integrated system 710. Integrated system 710 is further illustrated in the expanded view 720. In the exemplary embodiment, integrated system 710 includes an integrated circuitry 770 (labeled "Memory/Processor") includes at least one memory array (e.g., RAM), and/or at least one processor core (e.g., a microprocessor, a multi-core microprocessor, or graphics processor, or the like) having the characteristics discussed herein. In an embodiment, integrated circuitry 770 is a microprocessor a vertically stacked arrangement of peripheral circuitry and multiple memory arrays which, for example, are in various respective back-to-face configurations. Integrated circuitry 770 may be further coupled to (e.g., communicatively coupled to) a board, a substrate, or an interposer along with, one or more of a power management integrated circuit (PMIC) 730, RF (wireless) integrated circuitry (RFIC) 725 including a wideband RF (wireless) transmitter and/or receiver (TX/RX) (e.g., including a digital baseband and an analog front end module further comprises a power amplifier on a transmit path and a low noise amplifier on a receive path), and a controller 735.

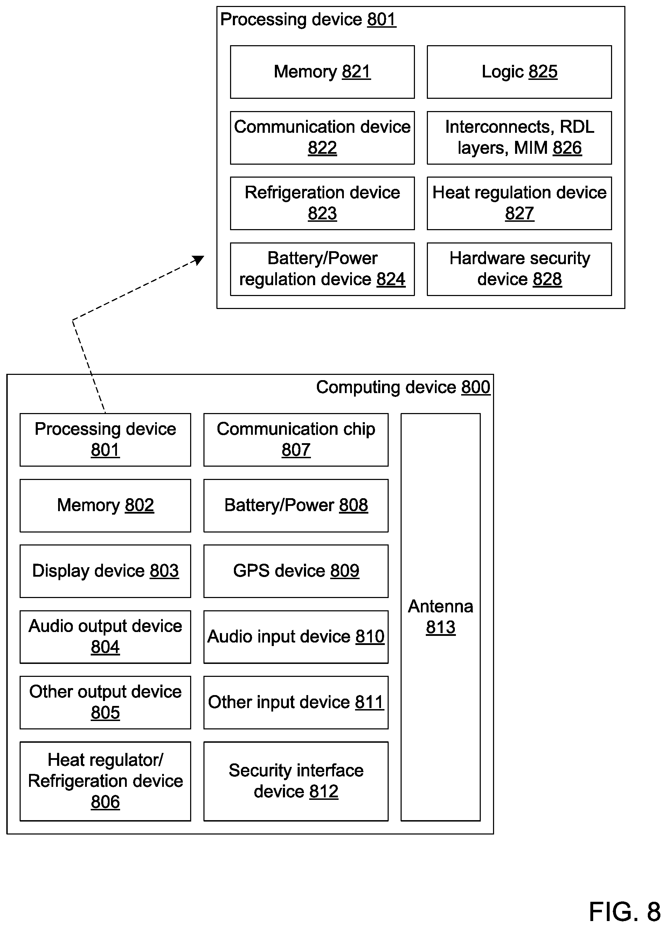

FIG. 8 is a block diagram of a computing device 800 in accordance with some embodiments. For example, one or more components of computing device 800 may include any of the devices or structures discussed elsewhere herein. Exemplary components are illustrated in FIG. 8 as included in computing device 800, but any one or more of these components may be omitted or duplicated, as suitable for the application. In some embodiments, some of the components included in computing device 800 may be attached to one or more printed circuit boards (e.g., a motherboard). In some embodiments, various ones of these components may be fabricated onto a single system-on-a-chip (SoC) die. Additionally, in various embodiments, computing device 800 may not include one or more of the components illustrated in FIG. 8, but computing device 800 may include interface circuitry for coupling to the one or more components. For example, computing device 800 may not include a display device 803, but may include display device interface circuitry (e.g., a connector and driver circuitry) to which display device 803 may be coupled.

Computing device 800 may include a processing device 801 (e.g., one or more processing devices). As used herein, the term processing device or processor indicates a device that processes electronic data from registers and/or memory to transform that electronic data into other electronic data that may be stored in registers and/or memory. Processing device 801 may include a memory 821, a communication device 822, a refrigeration/active cooling device 823, a battery/power regulation device 824, logic 825, interconnects 826 (i.e., optionally including redistribution layers (RDL) or metal-insulator-metal (MIM) devices), a heat regulation device 827, and a hardware security device 828.

Processing device 801 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 801 may include a memory 802, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 821 includes memory that shares a die with processing device 801. This memory may be used as cache memory and may include embedded dynamic random-access memory (eDRAM) or spin transfer torque magnetic random-access memory (STT-M RAM).

Computing device 800 may include a heat regulation/refrigeration device 806. Heat regulation/refrigeration device 806 may maintain processing device 801 (and/or other components of computing device 800) at a predetermined low temperature during operation. This predetermined low temperature may be of various suitable temperatures adapted from conventional circuit cooling techniques.

In some embodiments, computing device 800 may include a communication chip 807 (e.g., one or more communication chips). For example, the communication chip 807 may be configured for managing wireless communications for the transfer of data to and from computing device 800. The term "wireless" and its derivatives may be used to describe circuits, devices, systems, methods, techniques, communications channels, etc., that may communicate data through the use of modulated electromagnetic radiation through a nonsolid medium.

Communication chip 807 may implement any wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project, etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 807 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 807 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 807 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 4G, 5G, and beyond. Communication chip 807 may operate in accordance with other wireless protocols in other embodiments. Computing device 800 may include an antenna 813 to facilitate wireless communications and/or to receive other wireless communications (such as AM or FM radio transmissions).

In some embodiments, communication chip 807 may manage wired communications, such as electrical, optical, or any other suitable communication protocols (e.g., the Ethernet). As noted above, communication chip 807 may include multiple communication chips. For instance, a first communication chip 807 may be dedicated to shorter-range wireless communications such as Wi-Fi or Bluetooth, and a second communication chip 807 may be dedicated to longer-range wireless communications such as GPS, EDGE, GPRS, CDMA, WiMAX, LTE, EV-DO, or others. In some embodiments, a first communication chip 807 may be dedicated to wireless communications, and a second communication chip 807 may be dedicated to wired communications.

Computing device 800 may include battery/power circuitry 808. Battery/power circuitry 808 may include one or more energy storage devices (e.g., batteries or capacitors) and/or circuitry for coupling components of computing device 800 to an energy source separate from computing device 800 (e.g., AC line power).

Computing device 800 may include a display device 803 (or corresponding interface circuitry, as discussed above). Display device 803 may include any visual indicators, such as a heads-up display, a computer monitor, a projector, a touchscreen display, a liquid crystal display (LCD), a light-emitting diode display, or a flat panel display, for example.

Computing device 800 may include an audio output device 804 (or corresponding interface circuitry, as discussed above). Audio output device 804 may include any device that generates an audible indicator, such as speakers, headsets, or earbuds, for example.

Computing device 800 may include an audio input device 810 (or corresponding interface circuitry, as discussed above). Audio input device 810 may include any device that generates a signal representative of a sound, such as microphones, microphone arrays, or digital instruments (e.g., instruments having a musical instrument digital interface (MIDI) output).

Computing device 800 may include a global positioning system (GPS) device 809 (or corresponding interface circuitry, as discussed above). GPS device 809 may be in communication with a satellite-based system and may receive a location of computing device 800, as known in the art.

Computing device 800 may include another output device 805 (or corresponding interface circuitry, as discussed above). Examples include an audio codec, a video codec, a printer, a wired or wireless transmitter for providing information to other devices, or an additional storage device.

Computing device 800 may include another input device 811 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 800 may include a security interface device 812. Security interface device 812 may include any device that provides security measures for computing device 800 such as intrusion detection, biometric validation, security encode or decode, managing access lists, malware detection, or spyware detection,

Computing device 800, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

In one or more first embodiments, an integrated circuit (IC) die comprises a first active layer comprising first metal-oxide-semiconductor field-effect transistors (MOSFETs), wherein first memory cells of a first memory array comprise the first MOSFETs, a second active layer comprising second MOSFETs, wherein second memory cells of a second memory array comprise the second MOSFETs, and a third active layer comprising third MOSFETs, wherein peripheral circuit logic, which comprises the third MOSFETs, is coupled to access the first memory array and the second memory array, wherein the first active layer, the second active layer and the third active layer each correspond to a different respective transistor type, and the first, second and third active layers are coupled to each other in back-to-face arrangements.

In one or more second embodiments, further to the first embodiment, two or more of the first active layer, the second active layer and the third active layer each correspond to a different respective transistor topology type.

In one or more third embodiments, further to the first embodiment or the second embodiment, first metallization layers are between the first active layer and the third active layer, and the first metallization layers comprise an interconnect which is coupled between the peripheral circuit logic and each of the first memory array and the second memory array.

In one or more fourth embodiments, further to the third embodiment, respective structures of the first MOSFETs are formed in or on a semiconductor substrate of the first active layer, and hybrid bond structures are between the first metallization layers and the semiconductor substrate.

In one or more fifth embodiments, further to the first embodiment or the second embodiment, the first MOSFETs are each of a first transistor type which comprises a first channel length, the second MOSFETs are each of a second transistor type which comprises a second channel length that corresponds to the first channel length, the third MOSFETs are each of a third transistor type which comprises a third channel length that corresponds to the first channel length, the first channel length differs from the second channel length by at least 5% of the first channel length, and the second channel length differs from the third channel length by at least 5% of the second channel length.

In one or more sixth embodiments, further to the first embodiment or the first embodiment, the first memory cells comprise static random access memory (SRAM) cells, and the first active layer is between the second active layer and the third active layer.

In one or more seventh embodiments, further to the sixth embodiment, the third MOSFETs comprise gate-all-around transistors.

In one or more eighth embodiments, further to the sixth embodiment, the second memory cells comprise dynamic random access memory (DRAM) cells.

In one or more ninth embodiments, further to the sixth embodiment, the second memory cells comprise three-dimensional (3D) memory cells.

In one or more tenth embodiments, a system comprises an integrated circuit (IC) die comprising a first active layer comprising first metal-oxide-semiconductor field-effect transistors (MOSFETs), wherein first memory cells of a first memory array comprise the first MOSFETs, a second active layer comprising second MOSFETs, wherein second memory cells of a second memory array comprise the second MOSFETs, and a third active layer comprising third MOSFETs, wherein peripheral circuit logic, which comprises the third MOSFETs, is coupled to access the first memory array and the second memory array, wherein the first active layer, the second active layer and the third active layer each correspond to a different respective transistor type, and the first, second and third active layers are coupled to each other in back-to-face arrangements. The system further comprises a display device coupled to the IC die, the display device to display an image based on a signal communicated with the peripheral circuit logic.

In one or more eleventh embodiments, further to the tenth embodiment, two or more of the first active layer, the second active layer and the third active layer each correspond to a different respective transistor topology type.

In one or more twelfth embodiments, further to the tenth embodiment or the eleventh embodiment, first metallization layers are between the first active layer and the third active layer, and the first metallization layers comprise an interconnect which is coupled between the peripheral circuit logic and each of the first memory array and the second memory array.

In one or more thirteenth embodiments, further to the twelfth embodiment, respective structures of the first MOSFETs are formed in or on a semiconductor substrate of the first active layer, and hybrid bond structures are between the first metallization layers and the semiconductor substrate.

In one or more fourteenth embodiments, further to the tenth embodiment or the eleventh embodiment, the first MOSFETs are each of a first transistor type which comprises a first channel length, the second MOSFETs are each of a second transistor type which comprises a second channel length that corresponds to the first channel length, the third MOSFETs are each of a third transistor type which comprises a third channel length that corresponds to the first channel length, the first channel length differs from the second channel length by at least 5% of the first channel length, and the second channel length differs from the third channel length by at least 5% of the second channel length.

In one or more fifteenth embodiments, further to the tenth embodiment or the eleventh embodiment, the first memory cells comprise static random access memory (SRAM) cells, and the first active layer is between the second active layer and the third active layer.

In one or more sixteenth embodiments, further to the fifteenth embodiment, the third MOSFETs comprise gate-all-around transistors.

In one or more seventeenth embodiments, further to the fifteenth embodiment, the second memory cells comprise dynamic random access memory (DRAM) cells.

In one or more eighteenth embodiments, further to the fifteenth embodiment, the second memory cells comprise three-dimensional (3D) memory cells.

In one or more nineteenth embodiments, a method comprises forming a first active layer of an integrated circuit (IC) die, wherein the first active layer comprises first metal-oxide-semiconductor field-effect transistors (MOSFETs), wherein first memory cells of a first memory array comprise the first MOSFETs, forming a second active layer of the IC die, wherein the second active layer comprises second MOSFETs, wherein second memory cells of a second memory array comprise the second MOSFETs, and forming a third active layer of the IC die, wherein the third active layer comprises third MOSFETs, wherein peripheral circuit logic, which comprises the third MOSFETs, is coupled to access the first memory array and the second memory array, wherein the first active layer, the second active layer and the third active layer each correspond to a different respective transistor type, and the first, second and third active layers are coupled to each other in back-to-face arrangements.

In one or more twentieth embodiments, further to the nineteenth embodiment, two or more of the first active layer, the second active layer and the third active layer each correspond to a different respective transistor topology type.

In one or more twenty-first embodiments, further to the nineteenth embodiment or the twentieth embodiment, the method comprises forming first metallization layers between the first active layer and the third active layer, wherein the first metallization layers comprise an interconnect which is coupled between the peripheral circuit logic and each of the first memory array and the second memory array.

In one or more twenty-second embodiments, further to the twenty-first embodiment, respective structures of the first MOSFETs are formed in or on a semiconductor substrate of the first active layer, and hybrid bond structures are between the first metallization layers and the semiconductor substrate.

In one or more twenty-third embodiments, further to the nineteenth embodiment or the twentieth embodiment, the first MOSFETs are each of a first transistor type which comprises a first channel length, the second MOSFETs are each of a second transistor type which comprises a second channel length that corresponds to the first channel length, the third MOSFETs are each of a third transistor type which comprises a third channel length that corresponds to the first channel length, the first channel length differs from the second channel length by at least 5% of the first channel length, and the second channel length differs from the third channel length by at least 5% of the second channel length.

In one or more twenty-fourth embodiments, further to the nineteenth embodiment or the twentieth embodiment, the first memory cells comprise static random access memory (SRAM) cells, and the first active layer is between the second active layer and the third active layer.

In one or more twenty-fifth embodiments, further to the twenty-fourth embodiment, the third MOSFETs comprise gate-all-around transistors.

In one or more twenty-sixth embodiments, further to the twenty-fourth embodiment, the second memory cells comprise dynamic random access memory (DRAM) cells. In one or more twenty-seventh embodiments, further to the twenty-fourth embodiment, the second memory cells comprise three-dimensional (3D) memory cells.

Techniques and architectures for providing integrated circuit structures are described herein. In the above description, for purposes of explanation, numerous specific details are set forth in order to provide a thorough understanding of certain embodiments. It will be apparent, however, to one skilled in the art that certain embodiments can be practiced without these specific details. In other instances, structures and devices are shown in block diagram form in order to avoid obscuring the description.

Reference in the specification to "one embodiment" or "an embodiment" means that a particular feature, structure, or characteristic described in connection with the embodiment is included in at least one embodiment of the invention. The appearances of the phrase "in one embodiment" in various places in the specification are not necessarily all referring to the same embodiment.

Some portions of the detailed description herein are presented in terms of algorithms and symbolic representations of operations on data bits within a computer memory. These algorithmic descriptions and representations are the means used by those skilled in the computing arts to most effectively convey the substance of their work to others skilled in the art. An algorithm is here, and generally, conceived to be a self-consistent sequence of steps leading to a desired result. The steps are those requiring physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. Unless specifically stated otherwise as apparent from the discussion herein, it is appreciated that throughout the description, discussions utilizing terms such as "processing" or "computing" or "calculating" or "determining" or "displaying" or the like, refer to the action and processes of a computer system, or similar electronic computing device, that manipulates and transforms data represented as physical (electronic) quantities within the computer system's registers and memories into other data similarly represented as physical quantities within the computer system memories or registers or other such information storage, transmission or display devices.

Certain embodiments also relate to apparatus for performing the operations herein. This apparatus may be specially constructed for the required purposes, or it may comprise a general purpose computer selectively activated or reconfigured by a computer program stored in the computer. Such a computer program may be stored in a computer readable storage medium, such as, but is not limited to, any type of disk including floppy disks, optical disks, CD-ROMs, and magnetic-optical disks, read-only memories (ROMs), random access memories (RAMs) such as dynamic RAM (DRAM), EPROMs, EEPROMs, magnetic or optical cards, or any type of media suitable for storing electronic instructions, and coupled to a computer system bus.

The algorithms and displays presented herein are not inherently related to any particular computer or other apparatus. Various general purpose systems may be used with programs in accordance with the teachings herein, or it may prove convenient to construct more specialized apparatus to perform the required method steps. The required structure for a variety of these systems will appear from the description herein. In addition, certain embodiments are not described with reference to any particular programming language. It will be appreciated that a variety of programming languages may be used to implement the teachings of such embodiments as described herein.

Besides what is described herein, various modifications may be made to the disclosed embodiments and implementations thereof without departing from their scope. Therefore, the illustrations and examples herein should be construed in an illustrative, and not a restrictive sense. The scope of the invention should be measured solely by reference to the claims that follow.

## Claims

1. An integrated circuit (IC) die comprising:
a first active layer comprising first metal-oxide-semiconductor field-effect transistors (MOSFETs), wherein first memory cells of a first memory array comprise the first MOSFETs;
a second active layer comprising second MOSFETs, wherein second memory cells of a second memory array comprise the second MOSFETs; and
a third active layer comprising third MOSFETs, wherein peripheral circuit logic, which comprises the third MOSFETs, is coupled to access the first memory array and the second memory array;
wherein:
the first active layer, the second active layer and the third active layer each correspond to a different respective transistor type; and
the first, second and third active layers are coupled to each other in back-to-face arrangements.

2. The IC die of claim 1, wherein two or more of the first active layer, the second active layer and the third active layer each correspond to a different respective transistor topology type.

3. The IC die of either of claim 1 or claim 2, wherein:
first metallization layers are between the first active layer and the third active layer; and
the first metallization layers comprise an interconnect which is coupled between the peripheral circuit logic and each of the first memory array and the second memory array.

4. The IC die of claim 3, wherein:
respective structures of the first MOSFETs are formed in or on a semiconductor substrate of the first active layer; and
hybrid bond structures are between the first metallization layers and the semiconductor substrate.

5. The IC die of one of the previous claims, wherein:
the first MOSFETs are each of a first transistor type which comprises a first channel length;
the second MOSFETs are each of a second transistor type which comprises a second channel length that corresponds to the first channel length;
the third MOSFETs are each of a third transistor type which comprises a third channel length that corresponds to the first channel length;
the first channel length differs from the second channel length by at least 5% of the first channel length; and
the second channel length differs from the third channel length by at least 5% of the second channel length.

6. The IC die of one of the previous claims, wherein:
the first memory cells comprise static random access memory (SRAM) cells; and
the first active layer is between the second active layer and the third active layer.

7. The IC die of claim 6, wherein the third MOSFETs comprise gate-all-around transistors.

8. The IC die of claim 6 or 7, wherein the second memory cells comprise dynamic random access memory (DRAM) cells.

9. The IC die of claim 6, 7 or 8, wherein the second memory cells comprise three-dimensional (3D) memory cells.

10. A method comprising:
forming a first active layer of an integrated circuit (IC) die, wherein the first active layer comprises first metal-oxide-semiconductor field-effect transistors (MOSFETs), wherein first memory cells of a first memory array comprise the first MOSFETs;
forming a second active layer of the IC die, wherein the second active layer comprises second MOSFETs, wherein second memory cells of a second memory array comprise the second MOSFETs; and
forming a third active layer of the IC die, wherein the third active layer comprises third MOSFETs, wherein peripheral circuit logic, which comprises the third MOSFETs, is coupled to access the first memory array and the second memory array;
wherein:
the first active layer, the second active layer and the third active layer each correspond to a different respective transistor type; and
the first, second and third active layers are coupled to each other in back-to-face arrangements.

11. The method of claim 10, wherein two or more of the first active layer, the second active layer and the third active layer each correspond to a different respective transistor topology type.

12. The method of either of claim 10 or claim 11, further comprising:
forming first metallization layers between the first active layer and the third active layer, wherein the first metallization layers comprise an interconnect which is coupled between the peripheral circuit logic and each of the first memory array and the second memory array.

13. The method of claim 12, wherein:
respective structures of the first MOSFETs are formed in or on a semiconductor substrate of the first active layer; and
hybrid bond structures are between the first metallization layers and the semiconductor substrate.

14. The method of one of the claims 10-13, wherein:
the first memory cells comprise static random access memory (SRAM) cells; and
the first active layer is between the second active layer and the third active layer.

15. The method of claim 14, wherein the third MOSFETs comprise gate-all-around transistors.
